# EUROPEAN PATENT APPLICATION

(11) **EP 3 373 325 A1**
(43) Date of publication of application: **12.09.2018**
(21) Application number: 16862042.5
(22) Date of filing: 31.10.2016
(51) Int. Cl.: H01L 21/52

(54) **DIE BONDING DEVICE AND DIE BONDING METHOD**

(30) Priority: 05.11.2015 US 201562251484 P
(71) Applicant: Furukawa Electric Co. Ltd., Tokyo 100-8322 (JP)
(72) Inventor: NAKAMURA, Teruyuki, Tokyo 100-8322 (JP); SEKINO, Akira, Tokyo 100-8322 (JP); TANIGUCHI, Hidehiro, Tokyo 100-8322 (JP)
(74) Representative: Schwabe - Sandmair - Marx
(86) International application number: PCT/JP2016/082313
(87) International publication number: WO 2017/077982

(57) **Abstract**

A die bonding apparatus for bonding a second member to a first member includes: a mounting base including a mounting area on which the first member is mounted; a heater arranged below the mounting base; a side wall configured to surround the mounting area of the mounting base; a lid including a hole configured to allow the first and second members pass therethrough, the lid being mounted on the side wall; a collet configured to hold the second member by vacuum-chucking at an end portion; a moving structure configured to move the collet to transport the second member held by the collet through the hole for bonding the second member to the first member; and a gas-supplying tube arranged on the side wall and configured to supply a heating gas to a heating space formed by the side wall and the lid, and the lid contains a material capable of: reflecting an infrared radiation caused by the heater and the heating gas; or absorbing and re-radiating the infrared radiation.

## Description

### Field

The present invention relates to a die bonding apparatus and a die bonding method.

### Background

A die bonding apparatus is used for bonding a first member such as a support base member to a second member such as a semiconductor chip (see Patent Literatures 1 and 2). Usually, the die bonding apparatus performs the bonding by heating the first member to melt a brazing material applied on its surface, or by supplying a brazing material to the first member on a heater, heating and melting the brazing material, and then contacting the first member with the second member. The brazing material used for the bonding is, for example, solder or electrically conductive adhesive.

### Citation List

### Patent Literature

Patent Literature 1: Japanese Patent No. 4935491
Patent Literature 2: Japanese Laid-open Patent Publication No. 2009-81218

### Summary

### Technical Problem

However, when a temperature of the second member immediately before bonding is lower than a temperature of the brazing material on the surface of the first member, the brazing material would be solidified in a short period of time at the time of bonding; therefore, a bonding operation may be completed without sufficient wettability between the brazing material and the second member. In this case, there is a problem that a thermal resistance between the first member and the second member increases and the property and reliability of the second member may decrease. Moreover, when a size of the second member is large such as a chip of a long-cavity-type semiconductor laser element and a chip of a laser bar in which semiconductor lasers are arranged in arrays, the bonding operation may be completed with a region having locally insufficient wettability due to a warp in a longitudinal direction of the chip. In this case, there may also be the problem of decreasing property and reliability of the chips.

The present invention was made in consideration of the above-described circumstances, and it is an object of the present invention to provide a die bonding apparatus and a die bonding method that are capable of performing a preferable bonding without decreasing property and reliability of members.

### Solution to Problem

To solve the above-described problem and achieve the object, a die bonding apparatus according to one aspect of the present invention is a die bonding apparatus for bonding a second member to a first member, including: a mounting base including a mounting area on which the first member is mounted; a heater arranged below the mounting base; a side wall configured to surround the mounting area of the mounting base; a lid including a hole configured to allow the first and second members pass therethrough, the lid being mounted on the side wall; a collet configured to hold the second member by vacuum-chucking at an end portion; a moving structure configured to move the collet to transport the second member held by the collet through the hole for bonding the second member to the first member; and a gas-supplying tube arranged on the side wall and configured to supply a heating gas to a heating space formed by the side wall and the lid, wherein the lid contains a material capable of: reflecting an infrared radiation caused by the heater and the heating gas; or absorbing and re-radiating the infrared radiation.

In the die bonding apparatus according to one aspect of the present invention, the lid is made of the material.

In the die bonding apparatus according to one aspect of the present invention, the lid includes a layer made of the material.

In the die bonding apparatus according to one aspect of the present invention, the material is at least one of metal, ceramics, a heat-resistant resin and carbon.

In the die bonding apparatus according to one aspect of the present invention, the side wall has a multi-layer structure.

In the die bonding apparatus according to one aspect of the present invention, the gas-supplying tube is configured to inject the heating gas in a direction away from the hole of the lid when viewed from the lid.

In the die bonding apparatus according to one aspect of the present invention, the gas-supplying tube is configured to inject the heating gas toward the mounting base.

In the die bonding apparatus according to one aspect of the present invention, the heating gas is an inert gas, a reducing gas, or a mixture gas of the inert gas and the reducing gas.

In the die bonding apparatus according to one aspect of the present invention, a vacuum-chucking area of the collet is smaller than an area in which the second member is vacuum-chucked.

In the die bonding apparatus according to one aspect of the present invention, the collet is a round collet.

In the die bonding apparatus according to one aspect of the present invention, an end portion of the collet is made of a resin.

In the die bonding apparatus according to one aspect of the present invention, the second member is 4 mm or longer in a longitudinal direction.

A die bonding method according to one aspect of the present invention is a die bonding method for bonding a second member to a first member, including: a mounting step of mounting the first member on a mounting area of a mounting base; a heating step of heating the first member by a heater; a gas-supplying step of supplying a heating gas to a heating space formed by the mounting base, a side wall configured to surround the mounting area of the mounting base, and a lid including a hole configured to allow the first and second members to pass therethrough, the lid being mounted on the side wall; and a bonding step of introducing the second member held by the collet into the heating space through the hole of the lid and bonding the second member to the first member by contacting the second member with the first member, wherein the lid contains a material capable of: reflecting an infrared radiation caused by the heater and the heating gas; or absorbing and re-radiating the infrared radiation.

In the die bonding method according to one aspect of the preset invention, the second member is transported inside the heating space at a first speed, and thereafter, the second member is transported at a second speed which is faster than the first speed to contact with the first member.

In the die bonding method according to one aspect of the preset invention, transportation of the second member is paused inside the heating space, and thereafter, the second member is transported to contact with the first member.

In the die bonding method according to one aspect of the preset invention, the second member is 4 mm or longer in a longitudinal direction.

### Advantageous Effects of Invention

The present invention attains an effect of performing a preferable bonding without decreasing property and reliability of members.

### Brief Description of Drawings

FIG. 1 is a schematic partially-cut-off side view of a die bonding apparatus according to an embodiment.
FIG. 2 is a schematic plan view of the die bonding apparatus illustrated in FIG. 1.
FIG. 3 is a schematic view explaining a die bonding method using the die bonding apparatus illustrated in FIG. 1.
FIG. 4 is a schematic view explaining a die bonding method using the die bonding apparatus illustrated in FIG. 1.
FIG. 5 is a schematic view explaining a relationship between a semiconductor chip and an end portion of a collet.
FIG. 6 is a schematic view explaining an arrangement example 1 of a gas-supplying tube.
FIG. 7 is a schematic view explaining an arrangement example 2 of the gas-supplying tube.
FIG. 8 is a schematic view explaining another structural example of the collet.
FIG. 9 is a schematic view explaining another structural example of a lid.

### Description of Embodiment

Next, an embodiment of the present invention will be explained in detail with reference to the drawings. The present invention is not limited to this embodiment.

### (Embodiment)

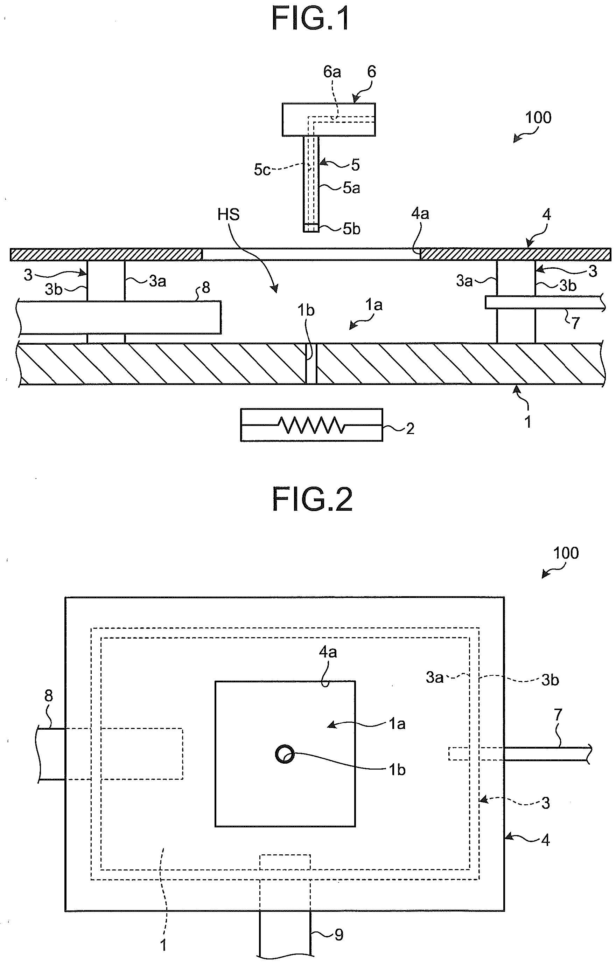

FIG. 1 is a schematic partially-cut-off side view of a die bonding apparatus according to the embodiment. FIG. 2 is a schematic plan view of the die bonding apparatus illustrated in FIG. 1. A die bonding apparatus 100 which will be explained later bonds a semiconductor laser element chip (hereinafter may be described as a semiconductor chip) as a second member to a sub-mount as a first member, and produces a chip-on-sub-mount.

The die bonding apparatus 100 includes a mounting base 1, a heater 2, a side wall 3, a lid 4, a collet 5, a moving structure 6 for the collet 5, a gas-supplying tube 7, and position-adjusting arms 8 and 9.

Although the mounting base 1 is made of stainless steel, the mounting base 1 may be made of other metal material such as copper or the like. The mounting base 1 includes a mounting area 1a. The sub-mount is mounted on a surface of the mounting area 1a. Moreover, a suction hole 1b communicating with a vacuum pump is formed in the mounting area 1a of the mounting base 1.

The heater 2 is arranged below the mounting area 1a of the mounting base 1. The side wall 3 is configured to surround the mounting area 1a of the mounting base 1 and has a multi-layer structure configured by two layers including a metal plate member 3a and a metal plate member 3b which are arranged with a space therebetween. The metal plate members 3a and 3b are made of stainless steel but may be made of other metal material such as copper or the like.

The lid 4 is mounted on the side wall 3. The lid 4 is a plate member made of stainless steel but may be a plate member made of other metal material such as copper or the like. The lid 4 has a hole 4a which is large enough to allow the sub-mount and the semiconductor chip to pass therethrough. The side wall 3 and the lid 4 form a heating space HS. The lid 4 is not fixed to the side wall 3 but detachable from the side wall 3. By this, it is easy to perform maintenance on (cleaning, adjustment or the like) the heating space HS by detaching the lid 4. Alternatively, the lid 4 and the side wall 3 may be monolithically formed or may have a structure for preventing gas leakage or thermal leakage caused by radiation. The hole 4a of the lid 4 mounted on the side wall 3 is positioned above the mounting area 1a of the mounting base 1.

The collet 5 includes: a main body portion 5a made of metal; and an end portion 5b made of polyimide resin, and the collet 5 is a round collet having a round end surface. Moreover, a suction hole 5c is formed in the collet 5. The suction hole 5c is opened at an end surface of the end portion 5b and communicates with the vacuum pump. The collet 5 can hold the semiconductor chip on the end portion 5b by sucking the semiconductor chip through the suction hole 5c by vacuum-chucking.

The collet 5 is attached to the moving structure 6. The moving structure 6 is a structure for moving the collet 5. A suction hole 6a is formed in the moving structure 6. The suction hole 5c communicates to the vacuum pump through the suction hole 6a.

The gas-supplying tube 7 is arranged to penetrate through the side wall 3 and supplies a heating gas to the heating space HS. The position-adjusting arms 8 and 9 penetrate through the side wall 3 and are arranged movably in directions orthogonal to each other. More specifically, the position-adjusting arm 8 is movable in a left-right direction on FIG. 2, and the position-adjusting arm 9 is movable in a up-down direction on FIG. 2. The position-adjusting arms 8 and 9 adjust a position of the sub-mount mounted on the mounting area 1a of the mounting base 1.

The die bonding apparatus 100 has a conveying mechanism (not illustrated) for moving the sub-mount to the mounting area 1a of the mounting base 1 and mounting the sub-mount on the mounting area 1a.

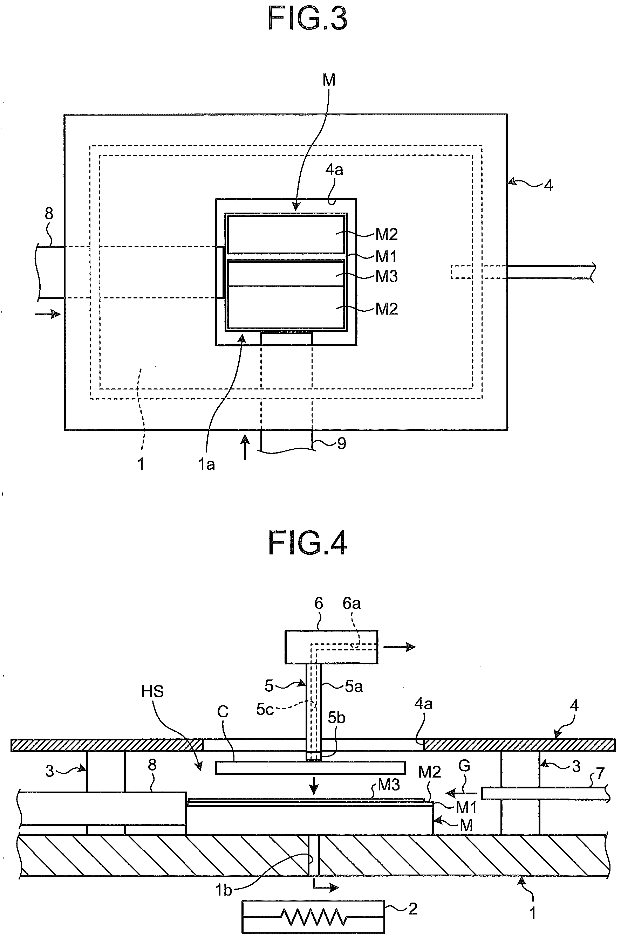

Next, a die bonding method using the die bonding apparatus 100 will be explained with reference to FIGS. 3 and 4.

First, as illustrated in FIG. 3, a mounting step is performed in which the sub-mount M is passed through the hole 4a of the lid 4 by the conveying mechanism and mounted on the mounting area 1a of the mounting base 1. The sub-mount M is obtained by forming an electrode layer M2 and a brazing material layer M3 (an AuSn solder layer in the embodiment) in this order on a surface of a substrate M1. After the sub-mount M is mounted, a position of the mounted sub-mount M is precisely adjusted by moving the position-adjusting arms 8 and 9 from initial positions in directions illustrated in FIG. 3. Next, as indicated by an arrow illustrated in FIG. 4, the sub-mount M is sucked by a vacuum pump through the suction hole 1b of the mounting base 1 and is vacuum-chucked.

Next, a heating step is performed in which the sub-mount M is heated by the heater 2. Next, a gas-supplying step is performed in which a heating gas G is injected and supplied from the gas-supplying tube 7 as indicated by an arrow illustrated in FIG. 4 to the heating space HS. Hereby an inside of the heating space HS is heated. A temperature in the heating space HS is set appropriately for a semiconductor chip C to be bonded. Moreover, an output of the heater 2 is adjusted to make the temperature of the sub-mount M a temperature for melting the brazing material layer M3. If the temperature of the brazing material layer M3 is low, the brazing material layer M3 may be solidified too fast when bonding the brazing material layer M3. On the other hand, if the temperature is high, the brazing material layer M3 may be altered. For example, if the brazing material layer M3 is an AuSn solder layer and the temperature is high, a compound whose melting point is high may be produced and solidified. In order to prevent these problems, the output of the heater 2 is adjusted to make the temperature of the brazing material layer M3 appropriate.

Herein, the inside of the heating space HS is heated by the heater 2 and the heating gas G, an infrared radiation occurs from the mounting base 1 and the side wall '3. In the die bonding apparatus 100 of the embodiment, since the lid 4 is made of stainless steel that is a metal material, the lid 4 reflects, or absorbs and re-radiates the infrared radiation. As a result, the decrease of the temperature in the heating space HS is prevented.

Next, a bonding step is performed. Specifically, the semiconductor chip C held by the vacuum-chucking of the collet 5 is introduced into the heating space HS through the hole 4a of the lid 4 by the moving structure 6. The semiconductor chip C is heated preliminarily in the heating space HS. After that, the semiconductor chip C is contact with and pressed to the brazing material layer M3 of the sub-mount M with the collet 5 to perform the bonding. After that, by taking out the sub-mount M from the die bonding apparatus 100 and performing a predetermined wiring step between the electrode layer M2 and the semiconductor chip C, the chip-on-sub-mount is manufactured.

A time period from the heating step until the semiconductor chip C is contacted with and pressed to the brazing material layer M3 of the sub-mount M to perform the bonding is set not to alter the brazing material layer M3.

Moreover, in order to heat the semiconductor chip C to an appropriate temperature reliably, a semiconductor chip C may be transported inside the heating space HS at a relatively slow first speed and after that, the semiconductor chip C may be contacted with the sub-mount M at a second speed which is faster than the first speed. Alternatively, the transportation of the semiconductor chip C may be paused inside the heating space HS for a predetermined period, and after that, the semiconductor chip C may be transported to contact with the sub-mount M.

In the die bonding apparatus 100 according to the embodiment, as a result of the reflection, or absorption and re-radiation of the infrared radiation by the lid 4, the temperature inside the heating space HS is restrained from lowering. For that reason, the temperature of the semiconductor chip C immediately before bonding is maintained appropriately relative to the temperature of the brazing material layer M3 of the sub-mount M. Hereby, at the time of the bonding, the brazing material layer M3 is solidified with sufficient wettability between the brazing material layer M3 and the semiconductor chip C, and the bonding is completed. As a result, since thermal resistances of the semiconductor chip C and the sub-mount M are restricted or prevented from increasing, a property of the semiconductor chip C is restricted or prevented from being deteriorated, thus reliability improves.

In order to reduce a gap between the lid 4 and the side wall 3, it is preferable to make the lid 4 heavy. By reducing the gap, the heating gas G can be prevented from leaking via the gap.

If the lid 4 is made of a transparent material such as glass, although a bonding operation becomes visible, the infrared radiation would transmit through the lid, and the temperature of the semiconductor chip C immediately before bonding would decrease relative to the temperature of the brazing material layer M3 of the sub-mount M, and an increase in the thermal resistance might occur due to a poor bonding.

Especially, when the semiconductor chip C is large (for example, 4 mm or longer in a longitudinal direction), a warp may occur in the longitudinal direction of the chip. In this case, if the temperature of the semiconductor chip C is low, there exists an area of the semiconductor chip C contacting with the brazing material layer M3 early, and the temperature of the brazing material layer M3 decreases and the brazing material layer M3 may be solidified as soon as the area has contacted with the brazing material layer M3. In such a case, a wettability of an area contacting with the brazing material layer M3 later may be insufficient locally. By contrast, since the temperature of the semiconductor chip C immediately before bonding is maintained appropriately in the die bonding apparatus 100, generation of an area where wettability is insufficient locally as explained above is restricted or prevented.

In addition, since the side wall 3 has the multi-layer structure in the die bonding apparatus 100, heat inside the heating space HS is hardly dissipated, and so the temperature is restrained from decreasing more effectively.

Moreover, in order to maintain a high temperature uniformly in the heating space HS, it is preferable to make a volume of the heating space HS as small as possible (not make the volume large beyond the necessity) comparing to the sizes of the sub-mount M and the semiconductor chip C.

Although the heating gas G supplied from the gas-supplying tube 7 is nitrogen gas in the embodiment, for example, it may be other inert gas such as argon gas, reducing gas such as hydrogen gas, or mixture gas of inert gas and reducing gas. When the heating gas G is reducing gas, there is an effect of preventing oxidation of the brazing material layer M3. Alternatively, the heating gas G may be air.

In the die bonding apparatus 100, the end portion 5b of the collet 5 as a part contacting with the semiconductor chip C is made of a resin, and its thermal conductivity is lower than that of metal. As a result, decrease in the temperature of the semiconductor chip C caused by the heat of the semiconductor chip C conducted to the collet 5 is restricted or prevented. Moreover, a gap between the semiconductor chip C and the end portion 5b is reduced since the end portion 5b is made of a resin, adhesion between the semiconductor chip C and the end portion 5b increases. As a result, decrease in the temperature of the semiconductor chip C caused by an inflow of the gas from the gap is restricted or prevented. By using a resin having a lower hardness, the effect of decreasing the gap further increases. Moreover, since the end portion 5b is made of a resin, the semiconductor chip C is restricted or prevented from receiving an impact from the collet 5 when performing vacuum-chucking or the like. Although polyimide is an example for a preferable resin from viewpoints of heat resistance and hardness, other resins may be used.

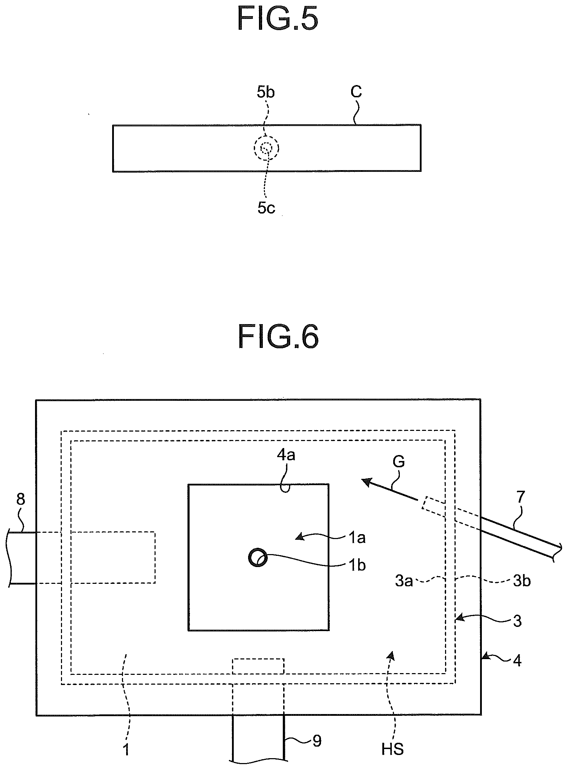

In the die bonding apparatus 100, the collet 5 is a round collet. FIG. 5 is a schematic view explaining a relationship between the semiconductor chip C and the end portion 5b of the collet 5. As illustrated in FIG. 5, an area of the end surface of the end portion 5b of the collet 5 is smaller than an area of a surface of the semiconductor chip C where the semiconductor chip C is vacuum-chucked. Therefore, an area of the suction hole 5c which is an area in which the collet 5 vacuum-chucks the semiconductor chip C is also smaller than the vacuum-chucked area of the semiconductor chip C. Hereby, when the collet 5 vacuum-chucks the semiconductor chip C, the suction hole 5c is prevented from being offset from the semiconductor chip C to cause inflow of gas from there. A round collet is preferable because it is easy to decrease the area of the suction hole 5c.

### (Another Arrangement Example of Gas-Supplying Tube)

FIG. 6 is a schematic view explaining an arrangement example 1 which is another arrangement example of the gas-supplying tube. In the arrangement example 1 illustrated in FIG. 6, the gas-supplying tube 7 is arranged such that the heating gas G is injected in a direction away from the hole 4a of the lid 4 when viewing the die bonding apparatus 100 from the lid 4. According to the arrangement example 1, the heating gas G injected from the gas-supplying tube 7 reaches the hole 4a linearly but does not flow to an outside of the heating space HS, thus tends to remain inside the heating space HS for a long time. As a result, it is possible to heat the heating space HS effectively.

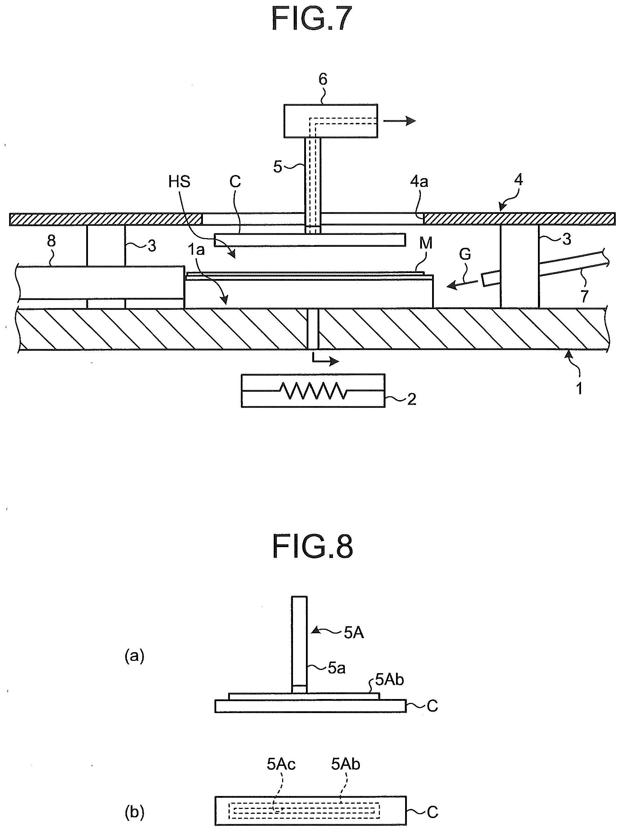

FIG. 7 is a schematic view explaining an arrangement example 2 for the gas-supplying tube. In the arrangement example 2 illustrated in FIG. 7, the gas-supplying tube 7 is arranged such that the heating gas G is injected toward the mounting base 1. According to the arrangement example 2, the heating gas G tends to remain in the heating space HS for a long time, thus it is possible to heat the heating space HS effectively. Moreover, it is also possible to heat the sub-mount M effectively by the heating gas G.

### (Another Structural Example for Collet)

FIG. 8 is a schematic view explaining another structural example for a collet. A drawing (a) in FIG. 8 is a side view and a drawing (b) in FIG. 8 is a schematic view explaining a relationship between the semiconductor chip and an end portion of the collet similarly to FIG. 5. A collet 5A includes the main body portion 5a made of metal and an end portion 5Ab made of polyimide resin and is a flat collet in which an end surface of the end portion 5Ab is rectangular. Similarly to the collet 5, a suction hole 5Ac which has an opening on an end surface of the end portion 5Ab and communicates with the vacuum pump is formed to the collet 5A. The collet 5A is capable of holding the semiconductor chip C at the end portion 5Ab by sucking and vacuum-chucking the semiconductor chip C through the suction hole 5Ac.

An area of the end surface of the end portion 5Ab of the collet 5A is smaller than a vacuum-chucked area of the semiconductor chip C. Therefore, an area of the suction hole 5Ac which is an area where the collet 5A vacuum-chucks the semiconductor chip C is also smaller than the vacuum-chucked area of the surface of the semiconductor chip C. Hereby, when the collet 5A vacuum-chucks the semiconductor chip C, the suction hole 5Ac is prevented from being offset from the semiconductor chip C to cause inflow of gas from there.

When using the flat collet having a shape illustrated in FIG. 8, there is an effect that a warp of the semiconductor chip C in a chucked state decreases because the semiconductor chip C can be chucked with a wide area along with a longitudinal direction. However, since a length of an outer periphery of the suction hole 5Ac increases, a gap between the semiconductor chip C and the suction hole 5Ac tends to be generated, thus an inflow of gas from there decreases the temperature of the semiconductor chip C. Therefore, the shape of the end portion 5Ab should be set in consideration of the effect of decreasing the warp and an influence of the tendency of the generation of the gap.

### (Another Structural Example for Lid)

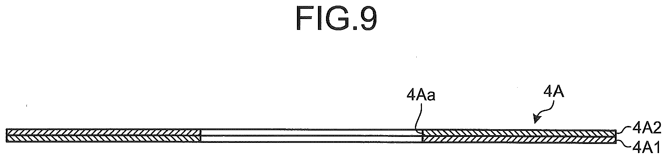

FIG. 9 is a schematic view explaining another structural example for a lid. A lid 4A having a hole 4Aa has a dual-layer structure formed by bonding a plate member 4A1 made of stainless steel and a plate member 4A2 made of glass. As explained above, the lid may be configured to include a layer made of a material which is capable of reflecting, or absorbing and re-radiating the infrared radiation, or may be configured to include the material. The material which is capable of reflecting, or absorbing and re-radiating the infrared radiation is at least one of metal, ceramics, various heat-resistant resin material, and carbon. Alternatively, the lid may be configured to include two or more of these materials.

### (Example, Comparative Example)

As an example 1, a plurality of samples of chip-on-sub-mounts were manufactured, in the configuration of the die bonding apparatus 100 according to the embodiment, by die-bonding the semiconductor chips having lengths of 1 to 5 mm on the sub-mounts by using a die bonding apparatus in which the collet was the flat collet. On the other hand, as a comparative example, a plurality of samples of chip-on-sub-mounts were manufactured, in the configuration of the die bonding apparatus according to the example 1, by die-bonding semiconductor chips having lengths of 1 to 5 mm on the sub-mounts by using a die bonding apparatus in which a glass plate was used as the lid. After that, the semiconductor chips were removed from the sub-mounts of the manufactured chip-on-sub-mounts, and bonding conditions thereof were examined. The comparative example is different from the example 1 only in the material of the lid. Table 1 shows the results. The temperature in the heating space (preliminary heating temperature) was changed between 100°C and 440°C, but the Table 1 only shows the result obtained at the temperature of 420°C.

**Table 1**

| Length (mm) | 1 | 2 | 3 | 4 | 5 |
|---|---|---|---|---|---|
| Comparative Example | good | good | poor | bad | bad |
| Example 1 | good | good | good | good | good |

As shown in the Table 1, in case of the comparative example, the bonding conditions of all the samples were good (as represented by "good") when the lengths of the semiconductor chips were 1 to 2 mm; however, the bonding conditions of some samples were poor (as represented by "poor") when the length of the semiconductor chip was 3 mm, and the bonding conditions of all the samples were poor (as represented by "bad") when the lengths of the semiconductor chips were 4 to 5. On the other hand, in the example 1, the bonding conditions of all the samples of the semiconductor chips were good in all lengths. When the bonding condition is "good", it indicates that a ratio of a trace of a chip remaining on the sub-mount after removing the semiconductor chip was 90% or more of a chip size.

Next, as an example 2, a plurality of samples of the chip-on-sub-mounts were manufactured by die-bonding the semiconductor chips having lengths of 4 mm on the sub-mounts by using a die bonding apparatus having the configuration of the die bonding apparatus 100 according to the embodiment (that is, the configuration using the round collet). Moreover, as an example 3, a plurality of samples of the chip-on-sub-mounts were manufactured by die-bonding the semiconductor chips having lengths of 4 mm on the sub-mounts by using the die bonding apparatus of the configuration of the example 2. However, in the example 3, the volume of the brazing material (AuSn solder) in the sub-mounts was increased to 1.5 to 3 times in comparison to those of the examples 1 and 2. After that, the semiconductor chips were removed from the sub-mounts of the manufactured chip-on-sub-mounts, and the bonding conditions were examined. Table 2 shows results together with results of the comparative example and results of the example 1 in which the lengths of the semiconductor chips were 4 mm.

**Table 2**

| Preliminary Heating Temperature (°C) | 360 | 380 | 400 | 420 | 440 |
|---|---|---|---|---|---|
| Comparative Example (3 mm or shorter) | bad | good | good | poor to good | bad |
| Comparative Example (4 mm or longer) | bad | bad | bad | bad | bad |
| Example 1 | bad | bad | good | good | bad |
| Example 2 | bad | good | good | good | bad |
| Example 3 | good | good | good | good | bad |

As shown in the Table 2, when the lengths of the semiconductor chips were 4 mm or longer in the comparative example, the bonding conditions of all the samples were poor at all of the temperatures. However, in the example 1, the bonding conditions of all the samples were good in the temperature range of 400°C to 420°C. Moreover, in the example 2, the bonding conditions of all the samples were good in the temperature range of 380°C to 420°C. Moreover, in the example 3, the bonding conditions of all the samples were good in the temperature range of 360°C to 420°C.

The invention is not limited to the above-described Embodiment. The invention includes a configuration appropriately combining the above-described elements. Further effects or modification examples may be derived by an ordinary skilled person in the art easily. Therefore, further wide aspects of the invention are not limited to the above-described Embodiments, and various modifications may be made.

### Industrial Applicability

As described above, the die bonding apparatus and the die bonding method according to the present invention are suitable for use in, for example, die bonding a semiconductor chip.

### Reference Signs List

- 1: mounting base
- 1a: mounting area
- 1b: suction hole
- 2: heater
- 3: side wall
- 3a, 3b: metal plate member
- 4, 4A: lid
- 4A1, 4A2: plate member
- 4a, 4Aa: hole
- 5, 5A: collet
- 5b, 5Ab: end portion
- 5c, 5Ac,: 6a suction hole
- 5a: main body portion
- 6: moving structure
- 7: gas-supplying tube
- 8, 9: position-adjusting arm
- 100: die bonding apparatus
- C: semiconductor chip
- G: heating gas
- HS: heating space
- M: sub-mount
- M1: substrate
- M2: electrode layer
- M3: brazing material layer

## Claims

1. A die bonding apparatus for bonding a second member to a first member, comprising:
a mounting base including a mounting area on which the first member is mounted;
a heater arranged below the mounting base;
a side wall configured to surround the mounting area of the mounting base;
a lid including a hole configured to allow the first and second members pass therethrough, the lid being mounted on the side wall;
a collet configured to hold the second member by vacuum-chucking at an end portion;
a moving structure configured to move the collet to transport the second member held by the collet through the hole for bonding the second member to the first member; and
a gas-supplying tube arranged on the side wall and configured to supply a heating gas to a heating space formed by the side wall and the lid, wherein
the lid contains a material capable of: reflecting an infrared radiation caused by the heater and the heating gas; or absorbing and re-radiating the infrared radiation.

2. The die bonding apparatus according to claim 1, wherein the lid is made of the material.

3. The die bonding apparatus according to claim 1, wherein the lid includes a layer made of the material.

4. The die bonding apparatus according to any one of claims 1 to 3, wherein the material is at least one of metal, ceramics, a heat-resistant resin and carbon.

5. The die bonding apparatus according to any one of claims 1 to 4, wherein the side wall has a multi-layer structure.

6. The die bonding apparatus according to any one of claims 1 to 5, wherein the gas-supplying tube is configured to inject the heating gas in a direction away from the hole of the lid when viewed from the lid.

7. The die bonding apparatus according to any one of claims 1 to 5, wherein the gas-supplying tube is configured to inject the heating gas toward the mounting base.

8. The die bonding apparatus according to any one of claims 1 to 7, wherein the heating gas is an inert gas, a reducing gas, or a mixture gas of the inert gas and the reducing gas.

9. The die bonding apparatus according to any one of claims 1 to 8, wherein a vacuum-chucking area of the collet is smaller than an area in which the second member is vacuum-chucked.

10. The die bonding apparatus according to claim 9, wherein the collet is a round collet.

11. The die bonding apparatus according to any one of claims 1 to 10, wherein an end portion of the collet is made of a resin.

12. The die bonding apparatus according to any one of claims 1 to 11, wherein the second member is 4 mm or longer in a longitudinal direction.

13. A die bonding method for bonding a second member to a first member, comprising:
a mounting step of mounting the first member on a mounting area of a mounting base;
a heating step of heating the first member by a heater;
a gas-supplying step of supplying a heating gas to a heating space formed by the mounting base, a side wall configured to surround the mounting area of the mounting base, and a lid including a hole configured to allow the first and second members to pass therethrough, the lid being mounted on the side wall; and
a bonding step of introducing the second member held by the collet into the heating space through the hole of the lid and bonding the second member to the first member by contacting the second member with the first member, wherein
the lid contains a material capable of: reflecting an infrared radiation caused by the heater and the heating gas; or absorbing and re-radiating the infrared radiation.

14. The die bonding method according to claim 13, wherein the second member is transported inside the heating space at a first speed, and thereafter, the second member is transported at a second speed which is faster than the first speed to contact with the first member.

15. The die bonding method according to claim 13, wherein transportation of the second member is paused inside the heating space, and thereafter, the second member is transported to contact with the first member.

16. The die bonding method according to any one of claims 13 to 15, wherein the second member is 4 mm or longer in a longitudinal direction.
